# EUROPÄISCHE PATENTSCHRIFT

(11) **EP 1 837 908 B1**
(45) Veröffentlichungstag und Bekanntmachung des Hinweises auf die Patenterteilung: **11.02.2009**
(21) Anmeldenummer: 07005338.4
(22) Anmeldetag: 15.03.2007
(51) Int. Cl.: H01L 23/31

(54) **Leistungshalbleiterbauelement mit Sekundärpassivierungsschicht und zugehöriges Herstellungsverfahren**
High performance semiconductor component with secondary passivation layer and associated method of manufacture
Dispositif à semi-conducteur de puissance doté d'une couche de passivation secondaire et procédé de fabrication correspondant

(30) Priorität: 22.03.2006 DE 102006013077
(43) Veröffentlichungstag der Anmeldung: 26.09.2007
(73) Patentinhaber: SEMIKRON Elektronik GmbH & Co. KG, 90431 Nürnberg (DE)
(72) Erfinder: Simic, Dejan, 90579 Langenzenn (DE); König, Bernhard Dr., 90765 Fürth (DE)

(56) Entgegenhaltungen:
- DE-A1- 4 013 435
- US-A1- 2005 156 276
- US-B1- 6 352 940

## Beschreibung

Die Erfindung beschreibt ein Leistungshalbleiterbauelement mit mindestens einem pn- Übergang und einer Primär- sowie einer Sekundärpassivierungsschicht ebenso wie ein zugehöriges Herstellungsverfahren. Einen Ausgangspunkt der Erfindung bilden Leistungshalbleiterbauelemente wie sie beispielhaft aus der DE 40 13 435 A1 bekannt sind. Dort ist einerseits die Funktion von Passivierungsschichten und anderseits der Aufbau von Leistungshalbleiterbauelementen mit MESA Struktur ausführlich dargestellt.

Aus dieser Druckschrift sind Leistungshalbleiterbauelemente bekannt, die als Primärpassivierungsschicht beispielhaft Schichten aus amorphem Silizium, amorphem Siliziumcarbid oder auch amorphem wasserstoffhaltigen Kohlenstoff aufweisen. Bekannt ist weiterhin, dass derartige Primärpassivierungsschichten für Leistungshalbleiterbauelement in MESA wie auch in planarer Struktur aus einer Schichtfolge lithographisch strukturierter Schichten aufgebaut sind. Dies kann beispielhaft eine Schichtfolge aus Siliziumoxid, Polysilizium und einer weiteren Schicht aus Siliziumnitrit sein. Derartige Schichten oder Schichtfolgen, die die Primärpassivierungsschicht bilden, werden mittels aus der Herstellung von Halbleiterbauelementen bekannten Technologien hergestellt und strukturiert.

Gemäß dem Stand der Technik werden derartige Primärpassivierungsschichten häufig mittels einer Sekundärpassivierungsschicht beispielhaft mit einem sog. Photoimid abgedeckt, um diese besonders gegen mechanische und chemische Einflüsse zu schützen. Dieser Schutz ist beispielhaft notwendig bei der löttechnischen Verbindung des Leistungshalbleiterbauelements mit einem Substrat oder auch beim Einsatz von mittels dieser Leistungshalbleiterbauelemente aufgebauter Leistungshalbleitermodule in industriellen Umgebungen. Unter Photoimid wird hier ein Polyimid verstanden, das mittels eines Aufschleuderprozesses auf Leistungshalbleiterbauelemente im Waferverbund aufgetragen wird, anschließend strukturiert und teilweise chemisch, vorzugsweise nasschemisch, wieder entfernt und in einem weiteren Schritt polymerisiert wird.

Beispielhaft aus der DE 44 10 354 A1 ist eine Passivierungsschicht aus Glas, vorzugsweise Bleiglas, bekannt, die auf die Oberfläche eines Leistungshalbleiterbauelements mit planarer Struktur aufgeschleudert, anschließend gesintert und strukturiert wird. Primärpassivierungsschichten aus Glas werden in der Regel nicht durch eine weitere Sekundärpassivierungsschicht abgedeckt, da diese eine ausreichende Widerstandsfähigkeit gegen die meisten Umgebungsbedingungen aufweisen.

Die US 6,352, 940 B1 beschreibt ein Verfahren zur Passivierung eines integrierten Schaltkreises mit einer Isolationsschicht mittels einer ersten und einer zweiten Passivierungsschicht, wobei die erfinderische Lösung der Aufgabe darin besteht, zwischen der Isolationsschicht und der ersten Passivierungsschicht ein chemisches Gasgemisch, vorzugsweise ein Distickstoffmonoxid aufzubringen, welche mit der Isolationsschicht reagiert und eine adhesive Schichte (vorzugsweise ein Silikonoxynitrid) ausbildet, die die Haftung zur ersten Passivierungsschichte wesentlich verbessert.

Die US-A-20050156276 beschreibt ein Leistungshalbleiterelement mit einem pn-Übergang und mit einer Primärpassivierungsschicht, welche mit einem Polyimid als Sekundärpassivierungsschicht überdeckt ist.

Der Erfindung liegt die Aufgabe zugrunde ein Leistungshalbleiterbauelement sowie ein zugehöriges Herstellungsverfahren vorzustellen wobei mindestens eine Primärpassivierungsschicht durch eine Sekundärpassivierungsschicht in einfach herzustellender und kostengünstiger Weise abgedeckt und bevorzugt gegen mechanische und chemische Einflüsse geschützt ist.

Die Aufgabe wird erfindungsgemäß gelöst, durch die Maßnahmen der Merkmale der Ansprüche 1 und 4. Bevorzugte Ausführungsformen sind in den Unteransprüchen beschrieben.

Der erfinderische Gedanke geht aus von einem Leistungshalbleiterbauelement bestehend aus einem Halbleiterkörper, wobei dessen Grundkörper eine erste Leitfähigkeit aufweist. Der Halbleiterkörper weist weiterhin mindestens einen Teilkörper bzw. Bereiche mit einer zweiten Leitfähigkeit auf. Hierdurch wird mindestens ein pn- Übergang des Leistungshalbleiterbauelements ausgebildet. Grundsätzlich sind für die Halbleiterkörper derartiger Leistungshalbleiterbauelemente zwei Strukturvarianten bekannt. Eine erste Ausgestaltung ist als sog. MESA Strukturen bekannt während eine zweite Ausgestaltung mittels sog. planarer Strukturen ausgebildet ist. Die Erfindung bezieht sich auf beide bekannte Strukturen.

Leistungshalbleiterbauelemente der genannten Ausgestaltungen sind beispielhaft Dioden, Thyristoren oder Transistoren. Die Bereiche unterschiedlicher Leitfähigkeit der Teilkörper bzw. Bereiche des Halbleiterkörpers derartiger Leistungshalbleiterbauelemente werden durch eine geeignet Kombination von Epitaxie-, Diffusions- und Strukturierungsprozessen gebildet. Weiterhin notwendig zur Ausbildung des Leistungshalbleiterbauelements sind Metallisierungsprozesse für Kontaktflächen.

Dem Stand der Technik entsprechend weisen eine Vielzahl derartiger Leistungshalbleiterbauelemente eine Primärpassivierung mindestens einer Teilfläche mindestens einer Hauptfläche auf. Vorzugsweise werden hierbei Teilflächen abgedeckt an denen der pn- Übergang eine Außenfläche des Halbleiterkörpers erreicht. Die Reihenfolge der Prozessschritte Primärpassivierung und Metallisierung ist für diese Erfindung nicht maßgeblich.

Alle vorgenannten Verarbeitungsschritte finden vorzugsweise im Waferverbund vor der Vereinzelung in einzelne Leistungshalbleiterbauelemente statt.

Erfindungsgemäß wird auf mindestens eine der genannten Primärpassivierungsschichten mittels eines Siebdruckverfahrens eine diese Primärpassivierungsschicht überdeckende Sekundärpassivierungsschicht bestehend aus einem siebdruckfähigen Polyimid aufgebracht.

Es ist bevorzugt an den Prozessschritt des Siebdruckens einen Ausheizprozess des Polyimids anzuschließen und im Weiteren die Leistungshalbleiterbauelemente zu vereinzeln.

Es ist besonders bevorzugt, wenn das Polyimid bei Leistungshalbleiterbauelement in planarer Struktur eine Schichtdicke von mindestens 7µm, eine dynamische Viskosität von mindestens 32000cps, sowie einen Thixotropieindex von 2 bis 5 aufweist. Demgegenüber ist es bei Leistungshalbleiterbauelementen in MESA Struktur bevorzugt, wenn die Schichtdicke von mindestens 20µm beträgt, die dynamische Viskosität mindestens 125000cps und der Thixotropieindex mehr als 4 betragen.

Die Temperaturbeständigkeit des Polyimids sollte bevorzugt mindestens 440°C betragen. Für den Siebdruck des Polyimids ist eine Maschengröße des Drucksiebs von 200 bis 325mesh besonders bevorzugt.

Die erfinderische Lösung wird an Hand der Ausführungsbeispiele der Fig. 1 bis 3 weiter erläutert.

Fig. 1 zeigt ein erstes erfindungsgemäßes Leistungshalbleiterbauelement mit planarer Struktur.

Fig. 2 zeigt ein zweites erfindungsgemäßes Leistungshalbleiterbauelement mit planarer Struktur.

Fig. 3 zeigt ein erfindungsgemäßes Leistüngshalbleiterbauelement mit MESA Struktur.

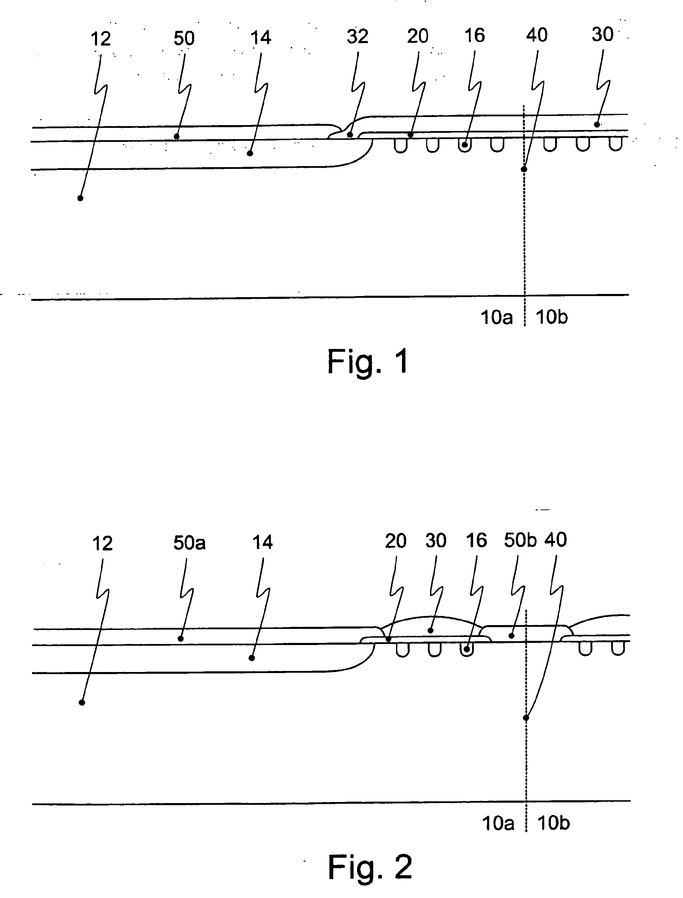

Fig. 1 zeigt schematisch ein erstes erfindungsgemäßes Leistungshalbleiterbauelement (10) mit planarer Struktur im Waferverbund. Dargestellt ist jeweils der Randbereich eines ersten (10a) und eines zweiten Leistungshalbleiterbauelements (10b) sowie die Linie (40) entlang derer nach allen Herstellungsschritten die Vereinzelung erfolgt. Der Halbleiterkörper des jeweiligen Leistungshalbleiterbauelements (10) weist einen Grundkörper erster Leitfähigkeit (12) sowie ein Diffusionsgebiet zweiter Leitfähigkeit (14) auf, wodurch ein pn- Übergang ausgebildet wird. Alternativ oder zusätzlich kann das Leistungshalbleiterbauelement (10) auch mittels Epitaxieverfahren hergestellte Gebiete aufweisen ohne dass hierdurch die Erfindung eingeschränkt wäre.

Als weitere Strukturen sind noch Potentialringe (16) zweiter Leitfähigkeit im Randbereich des Leistungshalbleiterbauelements (10) angedeutet. Diese Potentialringe (16) und der Bereich in dem der pn- Übergang die erste Hauptfläche des Leistungshalbleiterbauelements (10) erreicht sind mittels einer Primärpassivierungsschicht (20) bedeckt. Diese Primärpassivierungsschicht (20) kann gemäß des Standes der Technik als eine Einzelschicht, beispielhaft ein Oxidschicht, eine Siliziumnitritschicht oder auch eine Schicht aus amorphem Kohlenstoff, oder auch als eine Schichtfolge ausgebildet sein.

Die erfindungsgemäße Sekundärpassivierungsschicht (30) aus siebgedrucktem Polyimid, überdeckt die Primärpassivierungsschicht (20) vollständig. Weiterhin überlappt (32) diese Sekundärpassivierungsschicht (30) in Richtung des Diffusionsgebiets (14) zweiter Leitfähigkeit die Primärpassivierungsschicht (20) lateral, um hier eine besonders wirkungsvolle Abdeckung des pn- Übergangs zu erreichen. Eine Metallisierung (50) dient hier als elektrische Kontaktfläche des Leistungshalbleiterbauelements.

Fig. 2 zeigt schematisch ein zweites erfindungsgemäßes Leistungshalbleiterbauelement (10) mit planarer Struktur im Waferverbund. Der Halbleiterköper ist gleichartig demjenigen in Fig. 1 ausgebildet. Die Primärpassivierungsschicht überdeckt hierbei den pn- Übergang an der Oberfläche sowie die Potentialringe (16) nicht aber den Bereich im dem die Vereinzelung durchgeführt wird.

Eine erste Teilmetallisierung (50a) überdeckt den Bereich zweiter Leitfähigkeit (14) und bildet wiederum die elektrische Kontaktschicht. Eine zweite Teilmetallisierung (50b), die vorzugsweise identisch der ersten ausgebildet ist überdeckt den Bereich in dem die Vereinzelung durchführt wird. Beide Teilmetallisierungen (50 a/b) überdecken den jeweils zugeordneten Randbereich der Primärpassivierungsschicht (20). Der noch nicht überdeckte Bereich der Primärpassivierungsschicht (20) wird durch das siebgedruckte Polyimid (30) als Sekundärpassivierungsschicht überdeckt. Durch einen an den Siebdruckprozess anschließenden Polymerisierungsprozess mittels Erhitzen auf über 300°C bildet das Polyimid eine konvexe Oberfläche aus.

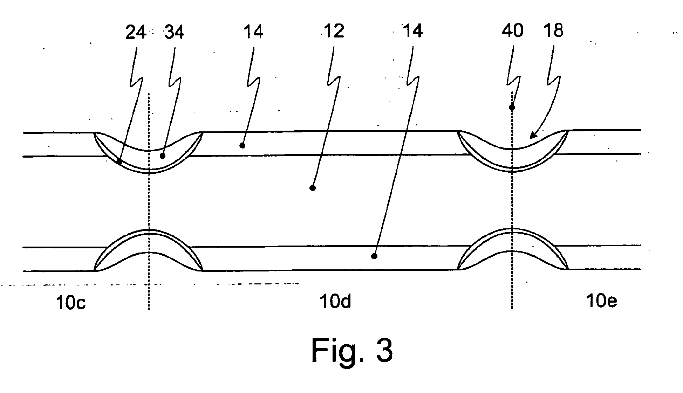

Fig. 3 zeigt schematisch die Halbleiterköper erfindungsgemäßer Leistungshalbleiterbauelemente (10 c/d/e) mit MESA Struktur im Waferverbund. Dargestellt ist der Grundkörper erster Leitfähigkeit (12) sowie zwei Diffusionsgebiete zweiter Leitfähigkeit (14). Diese Ausgestaltung entspricht der grundlegenden, nicht vollständigen, Ausgestaltung eines Leistungsthyristors.

Die Primärpassivierungsschicht (24) ist hier als Bleiglasschicht ausgebildet, die mittels bekannter Verfahren, beispielhaft durch eine Dispensereinheit, in den Gräben (18) des Halbleiterkörpers angeordnet wurde. Die erfindungsgemäße Sekundärpassivierungsschicht (34) besteht hier wiederum aus einem Polyimid, das mittels des Siebdruckprozesses in den Gräben (18) oberhalb der Primärpassivierungsschicht (24) angeordnet ist. Hierbei füllt das Polyimid den jeweiligen Graben (18) fast vollständig auf. Die Vereinzelung derartiger Leistungshalbleiterbauelemente (10 c/d/e) erfolgt wiederum entlang der Linie (40).

## Patentansprüche

1. Leistungshalbleiterbauelement (10) mit einem Halbleiterkörper mit mindestens einem pn- Übergang und mindestens einer auf einer Teilfläche einer Hauptfläche angeordneten Primärpassivierungsschicht (20, 24),
wobei mindestens eine dieser Primärpassivierungsschichten (20, 24) mittels eines siebdruckfähigen Polyimids (30, 34) als Sekundärpassivierungsschicht überdeckt ist, und wobei das Polyimid (30) mindestens einen Randbereich einer Primärpassivierungsschicht (20) lateral (32) überlappt.

2. Leistungshalbleiterbauelement (10) nach Anspruch 1
wobei das Leistungshalbleiterbauelement (10) in MESA- Struktur oder in planarer Struktur ausgebildet ist.

3. Leistungshalbleiterbauelement (10) nach einem der vorhergehenden Ansprüche, obei die Primärpassivierungsschicht (20, 24) durch das Polyimid (30, 34) vollständig überdeckt wird.

4. Verfahren zur Herstellungen eines Leistungshalbleiterbauelements (10) nach einem der vorgenannten Ansprüche,
**gekennzeichnet durch** die Verfahrensschritte:
• Durchführung aller Epitaxie- und/oder Diffusions- und Strukturierungsprozessen des Halbleiterkörpers;
• Primärpassivierung (20, 24) mindestens einer ersten Teilfläche mindestens einer Hauptfläche des Leistungshalbleiterbauelements (10);
• Metallisierung einer zweiten Teilfläche dieser Hauptfläche, wobei dieser Schritt vor oder auch nach dem Schritt der Primärpassivierung (20, 24) durchgeführt wird;
• Sekundärpassivierung anschließend an die vorgenannten Schritte, wobei mindestens ein nicht überdeckter Bereich mindestens einer Primärpassivierungsschicht (20, 24) mittels eines Siebdruckverfahrens mit einem siebdruckfähigen Polyimid (30, 32, 34) überdeckt wird, und wobei das Polyimid (30) mindestens einen Randbereich einer Primärpassivierungsschicht (20) lateral (32) überlappt;
• Vereinzelung der Leistungshalbleiterbauelemente (10).

5. Verfahren nach Anspruch 5,
wobei das Polyimid (30) für ein Leistungshalbleiterbauelement in planarer Struktur eine Schichtdicke von mindestens 7µm, eine Temperaturbeständigkeit bis mindestens 440°C, eine dynamische Viskosität von mindestens 32000cps, und eine Thixotropieindex von 2 bis 5 aufweist.

6. Verfahren nach Anspruch 5,
wobei das Polyimid (34) für ein Leistungshalbleiterbauelement in MESA Struktur eine Schichtdicke von mindestens 20µm, eine Temperaturbeständigkeit bis mindestens 440°C, eine dynamische Viskosität von mindestens 125000cps, und eine Thixotropieindex von mehr als 4 aufweist.

7. Verfahren nach Anspruch 5,
wobei sich an den Prozessschritt des Siebdruckens ein Ausheizprozess des Polyimids (30, 32, 34) anschließt.

8. Verfahren nach Anspruch 5,
wobei mittels dieses Siebdruckverfahrens Gräben (18) mit darin angeordneter Primärpassivierungsschicht (24) von im Waferverbund angeordneten Leistungshalbleiterbauelemente (10) in MESA Struktur zumindest teilweise mit Polyimid (34) verfüllt werden.

9. Verfahren nach Anspruch 5,
wobei das Sieb eine Maschengröße von 200 bis 325mesh aufweist.

## Claims

1. A high performance semiconductor component (10) with a semiconductor body with at least one pn transition and at least one primary passivation layer (20, 24) arranged on a partial surface of a main surface,
in which at least one of these primary passivation layers (20, 24) is covered by means of a screen-printable polyimide (30, 34) as secondary passivation layer, and in which the polyimide (30) overlaps at least an edge region of a primary passivation layer (20) laterally (32).

2. The high performance semiconductor component (10) according to Claim 1,
in which the high performance semiconductor component (10) is formed in MESA structure or in planar structure.

3. The high performance semiconductor component (10) according to any of the preceding claims, in which the primary passivation layer (20, 24) is completely covered by the polyimide (30, 34).

4. A method for the manufacture of a high performance semiconductor component (10) according to any of the above-mentioned claims,
**characterized by** the method steps:
- Carrying out all epitaxy and/or diffusion and structuring processes of the semiconductor body;
- Primary passivation (20, 24) at least of a first partial surface at least of a main surface of the high performance semiconductor component (10);
- Metallization of a second partial surface of this main surface, in which this step is carried out before or also after the step of primary passivation (20, 24);
- Secondary passivation following the above-mentioned steps, in which at least one region, which is not covered, at least of a primary passivation layer (20, 24) is covered by means of a screen printing process with a screen-printable polyimide (30, 32, 34), and in which the polyimide (30) overlaps at least an edge region of a primary passivation layer (20) laterally (32);
- Separation of the high performance semiconductor components (10).

5. The method according to Claim 5,
in which the polyimide (30) fora high performance semiconductor component in planar structure has a layer thickness of at least 7□m, a temperature stability up to at least 440°C, a dynamic viscosity of at least 32000cps, and a thixotropy index of 2 to 5.

6. The method according to Claim 5,
in which the polyimide (34) for a high performance semiconductor element in MESA structure has a layer thickness of at least 20□m, a temperature stability up to at least 440°C, a dynamic viscosity of at least 125000cps, and a thixotropy index of more than 4.

7. The method according to Claim 5,
in which a heating process of the polyimide (30, 32, 34) follows the process step of screen printing.

8. The method according to Claim 5,
in which by means of this screen printing method, trenches (18), with a primary passivation layer (24) arranged therein, of high performance semiconductor components (10), arranged in wafer composite, in MESA structure are at least partially filled with polyimide (34).

9. The method according to Claim 5,
in which the screen has a mesh size of 200 to 325 mesh.

## Revendications

1. Élément semiconducteur de puissance (10) avec un corps semiconducteur ayant au moins une transition pn et au moins une couche de passivation primaire (20, 24) disposée sur une surface partielle d'une surface principale, dans lequel au moins l'une de ces couches de passivation primaires (20, 24) est recouverte d'un polyimide (30, 34) applicable par sérigraphie et constituant une couche de passivation secondaire et dans lequel le polyimide (30) recouvre latéralement (32) au moins une zone marginale d'une couche de passivation primaire (20).

2. Élément semiconducteur de puissance (10) selon la revendication 1, dans lequel l'élément semiconducteur de puissance (10) est produit sous la forme d'une structure MESA ou d'une structure planaire.

3. Élément semiconducteur de puissance (10) selon l'une des revendications précédentes, dans lequel la couche de passivation primaire (20, 24) est entièrement recouverte par le polyimide (30, 34).

4. Procédé de fabrication d'un élément semiconducteur de puissance (10) selon l'une des revendications précédentes, **caractérisé par** les étapes consistant à :
- exécuter tous les processus d'épitaxie et/ou de diffusion et de structuration du corps semiconducteur ;
- réaliser une passivation primaire (20, 24) d'au moins une première surface partielle d'au moins une surface principale de l'élément semiconducteur de puissance (10) ;
- métalliser une seconde surface partielle de cette surface principale, cette étape pouvant être exécutée avant ou encore après l'étape de passivation primaire (20, 24) ;
- après les étapes précédentes, réaliser une passivation secondaire, au moins une zone non recouverte d'au moins une couche de passivation primaire (20, 24) étant, par un procédé de sérigraphie, recouverte par un polyimide (30, 32, 34) applicable par sérigraphie et le polyimide (30) recouvrant latéralement (32) au moins une zone marginale d'une couche de passivation primaire (20) ;
- séparer les éléments semiconducteurs de puissance (10).

5. Procédé selon la revendication 5, dans lequel le polyimide (30), pour un élément semiconducteur de puissance en structure planaire, présente une épaisseur de couche d'au moins 7 µm, une résistance à la température jusqu'à au moins 440 °C, une viscosité dynamique d'au moins 32 000 cps et un indice de thixotropie compris entre 2 et 5.

6. Procédé selon la revendication 5, dans lequel le polyimide (30), pour un élément semiconducteur de puissance en structure MESA, présente une épaisseur de couche d'au moins 20 µm, une résistance à la température jusqu'à au moins 440 °C, une viscosité dynamique d'au moins 125 000 cps et un indice de thixotropie supérieur à 4.

7. Procédé selon la revendication 5, dans lequel l'étape de procédé de sérigraphie est suivie par un processus d'étuvage du polyimide (30, 32, 34).

8. Procédé selon la revendication 5, dans lequel, grâce à ce procédé de sérigraphie, des fossés (18) comportant une couche de passivation primaire (24), appartenant à des éléments semiconducteurs de puissance (10) disposés sur une tranche et réalisés en structure MESA, sont au moins partiellement remplis de polyimide (34).

9. Procédé selon la revendication 5, dans lequel l'écran de sérigraphie a une taille de maille de 200 à 325 meshs.
